# EUROPEAN PATENT APPLICATION

(11) **EP 2 604 427 A1**
(43) Date of publication of application: **19.06.2013**
(21) Application number: 11816435.9
(22) Date of filing: 09.08.2011
(51) Int. Cl.: B32B 9/00, C23C 16/32, C23C 16/34, C23C 16/36, C23C 16/40, H01L 31/042

(54) **LAMINATE, AND LAMINATE PRODUCTION METHOD**

(30) Priority: 13.08.2010 JP 2010181207
(71) Applicant: Asahi Glass Company, Limited, Tokyo 100-8405 (JP)
(72) Inventor: KIHARA, Naoto, Tokyo 100-8405 (JP); NAKAO, Takuya, Tokyo 100-8405 (JP)
(74) Representative: Müller-Boré & Partner Patentanwälte
(86) International application number: PCT/JP2011/068191
(87) International publication number: WO 2012/020771

(57) **Abstract**

Provision of a laminate excellent in weather resistance and gas barrier property and also excellent in adhesion between layers and its durability; and a process for producing such a laminate.

A laminate which comprises a substrate sheet containing a fluororesin, and a gas barrier layer containing, as the main component, an inorganic compound composed of a metal and at least one member selected from the group consisting of oxygen, nitrogen and carbon, the gas barrier layer being directly laminated on at least one surface of the substrate sheet; wherein in a C1 s spectrum of a surface of the substrate sheet on which the gas barrier layer is laminated, that is measured by X-ray photoelectron spectroscopy, the position of the highest peak present within a binding energy range of from 289 to 291 eV is present within a range of from 290.1 to 290.6 eV.

## Description

### TECHNICAL FIELD

The present invention relates to a laminate useful as a protecting sheet for a solar cell module and a process for producing such a laminate.

### BACKGROUND ART

In recent years, a clean energy with higher safety is desired with a view to protecting the global environment. Among clean energies expected to be useful in the future, a solar cell is expected to be particularly prospective because of its cleanness, safety and handling efficiency.

The heart of a solar cell to convert sunlight to an electrical energy is cells. As such cells, those made of a semiconductor of monocrystalline, polycrystalline or amorphous silicon type are commonly used. A plurality of such cells are usually arranged in series or in parallel and further protected by various materials in order to maintain their function over a long period of time, to be used as a solar cell module.

A solar cell module usually has a structure such that the side of the cell exposed to sunlight is covered with tempered glass, and the backside is sealed with a back sheet, and a space between the cell and the tempered glass, and a space between the cell and the back sheet, are respectively, filled with a filler made of a thermoplastic resin, (particularly an ethylene/vinyl acetate polymer (hereinafter referred to as EVA)).

Such a solar cell module is required to have a product quality assurance for about 20 to 30 years. The solar cell module is mainly used outdoors, and its constituting materials are required to have weather resistance. Further, the tempered glass and the back sheet play a role to prevent deterioration of the interior of the module due to moisture and thus are also required to have a gas barrier property such as moisture barrier property.

The tempered glass is excellent in transparency, weather resistance and gas barrier property, but poor in flexibility, impact resistance, handling efficiency, etc. Therefore, it has been studied to use a resin sheet, particularly a fluororesin sheet excellent in weather resistance, instead of the tempered glass. However, the resin sheet has a problem such that the gas barrier property is low as compared with the tempered glass.

With respect to the above problem, it is proposed to provide an inorganic vapor deposition film for improving gas barrier property. For example, Patent Document 1 proposes a protection sheet that is a laminate of a fluororesin sheet and a resin sheet having a vapor deposition thin film of inorganic oxide. Further, Patent Document 2 proposes a protection sheet that is a fluororesin sheet having one surface provided with a vapor deposition thin film of inorganic oxide and further provided with an anti-fouling layer and/or a UV absorber layer in order to improve weather resistance.

Heretofore, in order to form the above inorganic vapor deposition film, a method such as a sputtering method or a plasma chemical vapor deposition (CVD) method using plasma has been employed since such a method can form a dense film having a high gas barrier property.

However, the above inorganic vapor deposition film has poor adhesion to a fluororesin sheet, particularly to a sheet containing an ethylene/tetrafluoroethylene copolymer as a fluororesin, and when a solar cell module has a filler layer provided so as to contact with the inorganic vapor deposition film, there occurs a problem that the inorganic vapor deposition film peels from the fluororesin sheet. When a gap is formed between the inorganic vapor deposition film and the filler layer by the peeling, e.g. penetration of moisture may occur to reduce the durability of a solar cell module.

In order to improve adhesion between the fluororesin sheet and the inorganic vapor deposition film, a surface treatment such as corona discharge treatment is applied on a surface of the fluororesin sheet. However, when such a surface treatment is applied, an initial adhesion improves to certain extent, but it is difficult to maintain the adhesion for a long period of time.

Meanwhile, in recent years, as a method for forming an inorganic vapor deposition film on a substrate, a method using a catalytic CVD method, a method using an atomic layer deposition method (ALD method) etc. are proposed.

For example, Patent Documents 3 and 4 each discloses a method for forming a silicon nitride film on a plastic substrate by a catalytic CVD method. Patent Document 5 discloses a method for forming a SiONC film on a substrate by a catalytic CVD method (hot wire CVD method).

Patent Document 6 discloses a method for forming an aluminum oxide thin film on a substrate by an ALD method, and reports that a pinhole-free dense aluminum oxide film is obtained by the method.

However, in Patent Documents 3 to 6, no fluororesin film is employed as a substrate, and these documents do not refer to adhesion with a fluororesin film. Further, such a sheet is designed for display element application such as an organic EL, and is not required to have a long term weather resistance of from 20 to 30 years and a gas barrier property that are required to a protection film for a solar cell.

### PRIOR ART DOCUMENTS

### PATENT DOCUMENTS

Patent Document 1: JP-A-2000-138387
Patent Document 2: JP-A-2000-208795
Patent Document 3: JP-A-2004-315899
Patent Document 4: JP-A-2006-57121
Patent Document 5: JP-A-2007-152772
Patent Document 6: JP-A-2002-161353

### DISCLOSURE OF INVENTION

### TECHNICAL PROBLEM

The present invention has been made in view of such a situation and is to provide a laminate which is excellent in weather resistance and gas barrier property and which is also excellent in interlayer adhesion and its durability, and a process for producing such a laminate.

### SOLUTION TO PROBLEM

In order to solve the above problem, the present invention provides the following embodiments.
[1] A laminate which comprises a substrate sheet containing a fluororesin, and a gas barrier layer containing, as the main component, an inorganic compound composed of a metal and at least one member selected from the group consisting of oxygen, nitrogen and carbon, the gas barrier layer being directly laminated on at least one surface of the substrate sheet;
   wherein in a C1s spectrum of a surface of the substrate sheet on which the gas barrier layer is laminated, that is measured by X-ray photoelectron spectroscopy, the position of the highest peak present within a binding energy range of from 289 to 291 eV is present within a range of from 290.1 to 290.6 eV.
[2] The laminate according to the above [1], wherein the fluororesin contains an ethylene/tetrafluoroethylene copolymer.
[3] The laminate according to the above [1] or [2], wherein in the C1s spectrum of the surface of the substrate sheet on which the gas barrier layer is laminated, as measured by X-ray photoelectron spectroscopy, the position of the maximum peak present in a binding energy range of from 284 to 286 eV is present within a range of from 285.0 to 285.9 eV.
[4] The laminate according to any one of the above [1] to [3], wherein the inorganic compound contains at least one member selected from the group consisting of a Si compound and an Al compound.
[5] The laminate according to the above [4], wherein the inorganic compound contains at least one member selected from the group consisting of silicon oxide, silicon nitride, silicon oxynitride, silicon oxynitric carbide and aluminum oxide.
[6] The laminate according to any one of the above [1] to [5], which is a protection sheet for a solar cell module.
[7] A process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by a catalytic vapor deposition method (hereinafter this process may be referred to as process 1).
[8] A process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by an ALD method (hereinafter this process may be referred to as process 2).
[9] The process according to the above [7] or [8], wherein the metal is silicon or aluminum.

### ADVANTAGEOUS EFFECTS OF INVENTION

According to the present invention, it is possible to provide a laminate which is excellent in weather resistance, gas barrier property, interlayer adhesion and its durability, and a process for producing such a laminate.

### BRIEF DESCRIPTION OF DRAWINGS

Fig. 1 is a graph showing C1s spectrum of an ETFE film surface measured by X-ray photoelectron spectroscopy in each of Comparative Example 1 (a laminate comprising an ETFE film and an aluminum oxide film formed on one surface of the ETFE film by a sputtering method), Example 2 (a laminate comprising an ETFE film and an aluminum oxide film formed on one surface of the ETFE film by an ALD method) and a reference example (an ETFE film).
Fig. 2 is a schematic construction view showing an example of film-forming apparatus employed for film-forming by a catalytic CVD method.
Fig. 3 is a schematic construction view showing an embodiment of film-forming apparatus employed for film-forming by an ALD method.

### DESCRIPTION OF EMBODIMENTS

The laminate of the present invention is a laminate which comprises a substrate sheet containing a fluororesin, and a gas barrier layer containing, as the main component, an inorganic compound composed of a metal and at least one member selected from the group consisting of oxygen, nitrogen and carbon, the gas barrier layer being directly laminated on at least one surface of the substrate sheet.

Now, the present invention will be described in further detail.

### <Substrate sheet>

The fluororesin to constitute the substrate sheet is not particularly limited so long as it is a thermoplastic resin containing fluorine atoms in the molecular structure of the resin, and various known fluororesins may be used. Specifically, a tetrafluoroethylene resin, a chlorotrifluoroethylene resin, a vinylidene fluoride resin, a vinyl fluoride resin, or a composite of two or more of such resins, may, for example, be mentioned. Among them, a tetrafluoroethylene resin or a chlorotrifluoroethylene resin is preferred, and a tetrafluoroethylene resin is particularly preferred, particularly from the viewpoint of excellent weather resistance, anti-fouling property, etc.

Specifically, the tetrafluoroethylene resin may, for example, be a polytetrafluoroethylene (PTFE), a tetrafluoroethylene/perfluoro(alkoxyethylene) copolymer (PFA), a tetrafluoroethylene/hexafluoropropylene/perfluoro(alkoxyethylene) copolymer (EPE), a tetrafluoroethylene/hexafluoropropylene copolymer (FEP), a ethylene/tetrafluoroethylene copolymer (ETFE) or an ethylene/trichlorofluoroethylene copolymer (ETCFE).

Each of such resins may further have a small amount of a comonomer component co-polymerized, as the case requires.

Such a comonomer component may be a monomer co-polymerizable with other monomers to constitute each resin (e.g. ethylene and tetrafluoroethylene in the case of ETFE), and for example, the following compounds may be mentioned.

A fluorinated ethylene such as CF₂=CFCl or CF₂=CH₂;
a fluorinated propylene such as CF₂=CFCF₃ or CF₂=CHCF₃;
a fluorinated alkylethylene having a C₂₋₁₀ fluoroalkyl group, such as CH₂=CHC₂F₅, CH₂=CHC₄F₉, CH₂=CFC₄F₉ or CH₂=CF(CF₂)₃H;
a perfluoro(alkyl vinyl ether) such as CF₂=CFO(CF₂CFXO)ₘR^{f} (wherein R^{f} is a C₁₋₆ perfluoroalkyl group, X is a fluorine atom or a trifluoromethyl group, and m is an integer of from 1 to 5);
a vinyl ether having a group which can be converted to a carboxylic acid group or a sulfonic acid group, such as CF₂=CFOCF₂CF₂CF₂COOCH₃ or CF₂=CFOCF₂CF(CF₃)OCF₂CF₂SO₂F.

As the tetrafluoroethylene resin, among the above, PFA, FEP, ETFE or ETCFE is preferred, and ETFE is particularly preferred from the viewpoint of the cost, mechanical strength, film-forming property, etc.

ETFE is a copolymer composed mainly of ethylene units and tetrafluoroethylene units. Here, "units" means repeating units constituting a polymer.

In whole units constituting ETFE, the total content of ethylene units and tetrafluoroethylene units is preferably at least 90 mol%, more preferably at least 95 mol%, and may be 100 mol%.

The molar ratio of ethylene units/tetrafluoroethylene units in ETFE is preferably from 40/60 to 70/30, more preferably from 40/60 to 60/40.

ETFE may have a small amount of comonomer component units, as the case requires. The comonomer component in such comonomer component units may be the same as mentioned above.

When ETFE has such comonomer component units, the content of the comonomer component units in whole units constituting ETFE is preferably from 0.3 to 10 mol%, more preferably from 0.3 to 5 mol%.

The chlorotrifluoroethylene resin may, for example, be one having tetrafluoroethylene in the above described tetrafluoroethylene resin substituted by chlorotrifluoroethylene. Specifically, a chlorotrifluoroethylene homopolymer (CTFE) or an ethylene/chlorotrifluoroethylene copolymer (ECTFE) may, for example, be mentioned.

The fluororesin contained in the substrate sheet may be of one type, or two or more types.

The substrate sheet may be one made solely of the fluororesin or may be one made of a resin mixture of the fluororesin and another thermoplastic resin. In consideration of the effects of the present invention, however, the substrate sheet is preferably composed mainly of the fluororesin. The proportion of the fluororesin in the substrate sheet is preferably at least 50 mass%, more preferably at least 70 mass%, based on the total mass of the substrate sheet.

Said another thermoplastic resin may, for example, be an acrylic resin, a polyester resin, a polyurethane resin, a nylon resin, a polyethylene resin, a polyimide resin, a polyamide resin, a polyvinyl chloride resin or a polycarbonate resin.

Further, it is also possible to use a resin having additives, fillers, etc. such as pigment, an ultraviolet absorber, carbon black, carbon fiber, silicon carbide, glass fiber, mica, etc. incorporated.

The shape and the size of the substrate sheet may be appropriately determined according to the purpose and they are not particularly limited. For example, when the laminate is employed as a protection sheet for a solar cell module, the shape and the size of the substrate sheet can be determined according to the shape and the size of the solar cell module.

The thickness of the substrate sheet is preferably at least 10 µm, more preferably at least 20 µm from the viewpoint of strength. The upper limit of the thickness may be appropriately determined according to the purpose, and it is not particularly limited. For example, when the laminate is employed as a protection sheet to be disposed on a side of the cell of the solar cell module, which is irradiated with sun light, the thickness is preferably thin from the viewpoint of high light transmittance in order to improve power generation efficiency, and it is specifically preferably at most 200 µm, more preferably at most 100 µm.

### <Gas barrier layer>

The gas barrier layer contains as the main component an inorganic compound composed of a metal and at least one member selected from the group consisting of oxygen, nitrogen and carbon.

Here, "as the main component" means that the ratio of the inorganic compound in the gas barrier layer is at least 95 mol%. The ratio of the inorganic compound in the gas barrier layer is preferably 100 mol%. Namely, the gas barrier layer is preferably composed of the inorganic compound.

As the metal constituting the inorganic compound, silicon, aluminum, indium, magnesium, zirconium, zinc, titanium, etc. may be mentioned. Among them, for the reason of excellence in transparency and water-vapor barrier property, etc. of a gas barrier layer formed, silicon or aluminum is preferred.

As the specific inorganic compound, a metal oxide, a metal nitride, a metal oxynitride, a metal oxynitric carbide, etc. may be mentioned.

As a specific example of the inorganic compound, a Si compound such as silicon oxide (hereinafter referred to as SiO), silicon nitride (hereinafter referred to as SiN), silicon oxynitride (hereinafter referred to as SiON) or silicon oxynitric carbide (hereinafter referred to as SiONC); an Al compound such as aluminum oxide (hereinafter referred to as AIO) or aluminum nitride (hereinafter referred to as AIN); an indium compound such as ln₂ O₃ ; a magnesium compound such as MgO; a zirconium compound such as zirconium oxide (hereinafter referred to as ZrO) or zirconium oxynitride (hereinafter referred to as ZrON); a zinc compound such as zinc oxide (hereinafter referred to as ZnO) or zinc oxynitride (hereinafter referred to as ZnON); or a titanium compound such as titanium oxide (hereinafter referred to as TiO) or titanium oxynitride (hereinafter referred to as TiON) may, for example, be mentioned.

Among them, for the reason of excellence in transparency and water-vapor barrier property etc., the inorganic compound is preferably a Si compound or an Al compound, more preferably at least one member selected from the group consisting of SiO, SiN, SiON, SiONC and AIO, still more preferably at least one member selected from the group consisting of SiON and AIO.

The gas barrier layer may be one constituted by a single layer, or it may be one constituted by a plurality of layers composed of different materials (for example, different inorganic compounds as the main component).

The thickness of the gas barrier layer (total film thickness when the film is constituted by a plurality of layers) is preferably at least 10 nm from the viewpoint of gas barrier property. Further, if the thickness is too large, the gas barrier property may decrease due to generation of cracks. Accordingly, the thickness is preferably at most 500 nm, more preferably at most 200 nm.

A gas barrier layer constituted by a plurality of layers composed of different materials is preferred since, although depending on the combination of materials, such a gas barrier layer has a high gas barrier property even if the thickness of each of the plurality of layers is thin. For example, even in a case where the thickness of a gas barrier layer constituted by a plurality of layers (the total thickness of the plurality of layers) is thinner than the thickness of the gas barrier layer constituted by a single layer, the gas barrier property obtained by the gas barrier layer constituted by a plurality of layers is higher in some cases. Further, a gas barrier layer constituted by two layers composed of different materials is more preferred than a gas barrier layer constituted by a plurality of layers of at least 3 since less production steps are required.

The gas barrier layer may be provided on one surface of the substrate sheet or it may be provided on each surface of the substrate sheet. From the viewpoint of productivity and practical use, it is preferred to provide the gas barrier layer on one surface of the substrate sheet.

The gas barrier layer is formed on at least one surface of the substrate sheet by a catalytic CVD method shown in a process 1 for producing a laminate of the present invention to be described later, or an ALD method as shown in a process 2 for producing a laminate of the present invention to be described later. By using the catalytic CVD method or the ALD method, in the C1 s spectrum of a surface of the substrate sheet on which the gas barrier layer is directly laminated, that is measured by X-ray photoelectron spectroscopy (hereinafter referred to as ESCA), the position of the highest peak present within a binding energy range of from 289 to 291 eV is present within a predetermined range.

However, the present invention is not limited thereto, and the gas barrier layer may be formed by a method other than the catalytic CVD method or the ALD method so long as the position of the highest peak present within the range of from 289 to 291 eV in the C1 s spectrum becomes within the predetermined range by the method.

In the laminate of the present invention, as described above, in the C1 s spectrum of a surface of the substrate sheet on which the gas barrier layer is laminated, that is measured by ESCA, the highest peak (hereinafter referred to as peak (1)) present in a binding energy range of from 289 to 291 eV is present within a range of from 290.1 to 290.6 eV, more preferably within a range of from 290.4 to 290.6 eV.

Here, the position of peak means that the position (binding energy) of peak top.

When the position of peak (1) is within the above range, the adhesion between the substrate sheet and the gas barrier layer and its long-term stability (adhesion durability) improve.

When a fluororesin constituting the substrate sheet contains ETFE, in the C1s spectrum, the position of the highest peak present within a binding energy range of from 284 to 286 eV (hereinafter referred to as peak (2)) is present within a range of from 285.0 to 285.9 eV, more preferably within a range of from 285.2 to 285.9 eV. When the position of peak (2) is present within the above range, adhesion between the substrate sheet and the gas barrier layer and its adhesion durability improve.

The above "C1s spectrum" is obtained by carrying out a narrow scan measurement with respect to carbon atoms present on a surface of a substrate sheet of the laminate on which a gas barrier layer is laminated (within a depth of from 2 to 5 nm from the outermost surface) by using an X-ray photoelectron spectroscopy apparatus (for example, Quantera SXM (µ-ESCA) manufactured by PHI). The narrow scan measurement is a measurement for carrying out quantitative analysis and analysis of chemical bonding state with respect to each of specific elements. Measurement conditions of the narrow scan at this time are set to be such that exciting X-ray: monochromatic AlKα ray (26.00 eV), power: 24.9 W, sample angle: 45°, measurement area size: 100 µm in diameter, pulse energy: 112 eV, and step energy: 0.1 eV.

The present inventors have paid attention to the relation between the adhesion or the adhesion durability and film-forming process of the gas barrier layer, and have conducted various studies. As a result, they obtained the following knowledge. Namely, in a case of forming a gas barrier layer by a process such as a sputtering method employing plasma, a fluororesin (ETFE etc) on a surface of the substrate sheet is damaged by plasma etching and becomes a resin of low molecular weight. A layer composed of such a fluororesin having a low molecular weight is called as a weak boundary layer (hereinafter abbreviated to as WBL). It is considered that such a layer not only has a weak bonding force and thus weakens initial adhesion, but also forms rupture of molecules from the WBL in a long term use to cause deterioration of adhesion durability.

Based on the above knowledge, the present inventors have further studied, and as a result, they discovered that the degree of damage of the surface of the substrate sheet by formation of the gas barrier layer can be evaluated by a shift amount of a peak within a predetermined range of the above C1s spectrum, and that when the shift amount is within a predetermined range, excellent adhesion and adhesion durability are obtained. Further, they discovered that when a catalytic CVD method or an ALD method is used for formation of the gas barrier layer, it is possible to make the above shift amount to be within a predetermined range.

Specific explanation will be made with respect to a case of employing an ETFE film as the substrate sheet as an example.

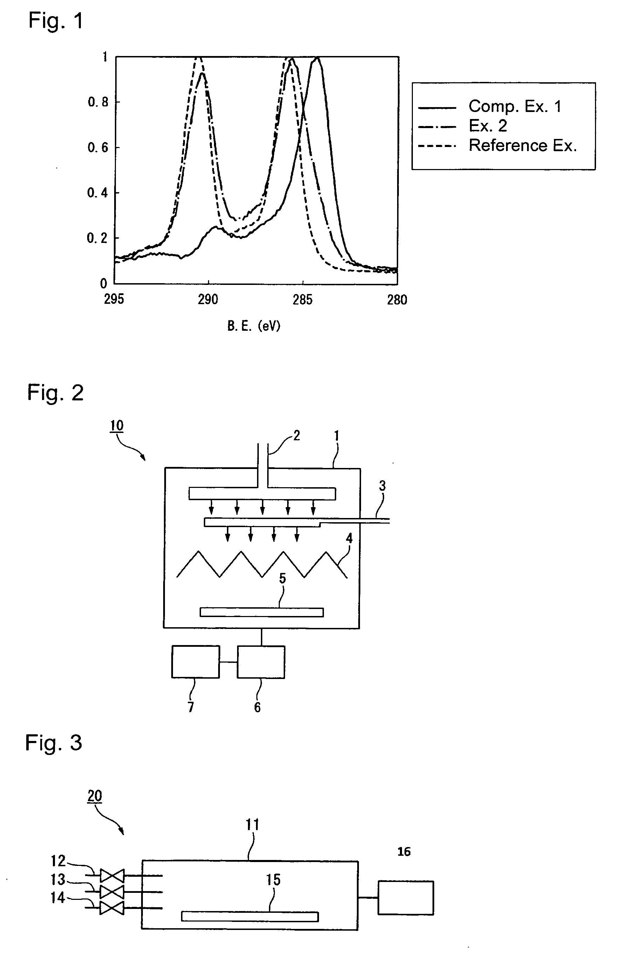

With respect to each of Comparative Example 1 (a laminate consisting of an ETFE film and an AIO film formed on one surface of the ETFE film by a sputtering method), Example 2 (a laminate consisting of an ETFE film and an AIO film formed on one surface of the ETFE film by an ALD method) and Reference Example (ETFE film only) in Examples to be described later, a C1 s spectrum of the surface of the ETFE film (with respect to Comparative Example 1 and Example 2, a surface on which an AIO film was formed), and as a result, the results shown in Fig. 1 were obtained.

Namely, in the case of C1s spectrum in reference example (ETFE film), the position of peak (1) was 290.6 eV, and the position of peak (2) was 285.9 eV. The peaks (1) and (2) in the C1 s spectrum correspond to CF₂ and CH₂, respectively, in the ETFE. Further, the intensity of peak (1) in the C1 s spectrum was 1.00 time the strength of peak (2). The ratio between the intensity of peak (1) and the intensity of the peak (2) changes depending on the molar ratio between tetrafluororethylene units and ethylene units in ETFE constituting the ETFE film.

On the other hand, in the case of the C1s spectrum in Comparative Example 1 (sputtering AIO), the position of peak (1) was 289.6 eV and the position of peak (2) was 284.3 eV, that were significantly shifted positions from those of Reference Example. Further, the intensity of peak (1) was 0.25 time the intensity of peak (2), that was significantly lowered as compared with Reference Example.

On the other hand, in the C1 s spectrum of Example 2 (ALD-AIO), the position of peak (1) was 290.4 eV, the position of peak (2) was 285.7 eV, and the shifting amounts in minus direction were significantly smaller than those of Comparative Example 1. Further, the intensity of peak (1) was 0.93 time the intensity of peak (2), it was substantially the same as that of Reference Example.

Here, by providing the gas barrier layer, the ratio between the intensity of peak (1) and the intensity of peak (2) (hereinafter it may be simply referred to as peak intensity ratio) becomes small. It is considered that as the change becomes smaller, decomposition of ETFE in the vicinity of the surface layer of the substrate sheet becomes more highly suppressed. For example, based on the peak intensity ratio (1.00) of Reference Example, the ratios of peak intensity ratios of Examples 1 and 2 are 0.96 and 0.93, respectively. On the other hand, the ratio of the peak intensity ratio of Comparative Example 1 based on the peak intensity ratio of Reference Example, is 0.25. From such a viewpoint, the ratio of the peak intensity ratio after the gas barrier layer is provided based on the peak intensity ratio before the gas barrier layer is provided, is preferably at least 0.6, more preferably at least 0.65, still more preferably at least 0.80.

The shift of peak (1) in minus direction is considered to be caused by decomposition of ETFE in the vicinity of the surface layer of an ETFE sheet and subsequent decomposition of CF₂ into CF. Further, the shift of peak (2) in minus direction is considered to be caused by decomposition of ETFE in the vicinity of the surface layer of the ETFE sheet and subsequent decomposition of CH₂ into e.g. C-C.

With an ALD method, little shift of these peaks occurred, which indicates that little damage occurred on a surface of the substrate sheet. Also in a case of using a catalytic CVD method, a similar result to the case of employing the ALD method was obtained. Then, adhesion and adhesion durability were actually evaluated, and as a result, as shown in Table 2 in Examples to be described, each of laminates of Examples 1 to 3, whose gas barrier layer was formed by an ALD method or a catalytic CVD method, maintained a high adhesion strength both in initial stage and after a weather resistance test.

Accordingly, in the present invention, it is presumed that reduction of molecular weight of fluororesin on a surface of the substrate sheet, that has been occurred in conventional processes employing plasma, is suppressed to be within a predetermined range, and accordingly, the initial adhesion (adhesion just after production) becomes high, and the adhesion hardly drops, whereby an excellent adhesion can be maintained for a long time.

As described above, the laminate of the present invention is excellent in weather resistance and gas barrier property, and is also excellent in adhesion between layers and adhesion durability. Namely, since the surface of the substrate sheet has predetermined characteristics, the adhesion between the substrate sheet and the gas barrier property is high, and the high adhesion is stably maintained for a long period of time.

Accordingly, the laminate of the present invention is useful as a protection sheet for a solar cell module.

For example, since the laminate has high adhesion and high adhesion durability, in a solar cell module wherein the laminate is disposed so that its gas barrier layer side surface faces to a filler layer side of e.g. an EVA, adhesion strength between the substrate sheet and the filler layer hardly drops.

Further, such a substrate sheet containing a fluororesin is excellent in weather resistance, heat resistance and chemical resistance, and is also excellent in anti-fouling property. Accordingly, when the laminate is disposed so that the outermost layer of the solar cell module becomes the substrate sheet, dust or particles hardly adhere to the surface of the solar cell module, and accordingly, it is possible to prevent deterioration of the performance due to dirt for a long period of time.

Further, in the laminate, the substrate sheet has a high transmittance, and with respect to the gas barrier layer, it is possible to achieve high transparency by appropriately selecting the material and the thickness. When the gas barrier layer has high transparency, the entire laminate has high transparency, and such a laminate is usable as a protection sheet for protecting a sunny side of each cell in a solar cell module.

Here, in the case of employing the laminate of the present invention as a protection sheet for protecting a sunny side of each cell in a solar cell module, the visible light transmittance of the laminate is preferably at least 80%, more preferably at least 90%. Its upper limit is not particularly limited since the visible light transmittance is preferably high, but it is practically about 98%.

### <Process 1 for producing laminate>

The process 1 for producing a laminate of the present invention is a process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by a catalytic CVD method (that is catalytic chemical vapor deposition method).

Explanations of the substrate sheet and the gas barrier layer are the same as explanations of the substrate sheet and the gas barrier layer of the laminate of the present invention.

Process 1 of the present invention can be carried out by employing a known film-forming apparatus for catalytic CVD method. As such a film-forming apparatus, there are a batch type, a roll to roll (R to R) type, etc.

For example, in a case of employing a batch type film-forming apparatus, the process 1 of the present invention can be conducted by carrying out a step of disposing a substrate sheet on a substrate holder of a vacuum container provided with the substrate holder for holding the substrate sheet and a catalytic body that is heatable and disposed above the substrate holder in the vacuum container, and evacuating the vacuum container; and
a step of introducing a material gas into the evacuated vacuum container, and heating the catalytic body, thereby decomposing the material gas introduced into the vacuum container, and depositing the decomposed product on a surface of the substrate sheet to form a gas barrier layer.

Now, process 1 of the present invention will be described in detail with reference to an example of embodiment.

Fig. 2 is a schematic construction view showing an embodiment of a batch-type film-forming apparatus 10 to be employed for film-forming using a catalytic CVD method.

The film-forming apparatus 10 comprises a chamber (vacuum container) 1, a first material gas supply unit 2 for supplying a material gas into the chamber 1, a second material gas supply unit 3 for supplying a material gas into the chamber 1, a catalytic body 4, a substrate holder 5, and an evacuation means for evacuating inside the chamber 1 to produce a vacuum state, and the evacuation means is constituted by a turbo molecular pump 6 and a rotary pump 7.

As the catalytic body 4, a metal wire, that can be heated to a temperature capable of decomposing the material gas, by e.g. electric conduction, is usually employed. As the metal, platinum, iridium, tungsten, tuntar etc. may be mentioned, and tungsten is preferred.

To the catalytic body 4, a power source for heating, not shown, is connected so that the catalytic body can be heated.

The catalytic body 4 is disposed above the substrate holder 5 in the chamber 1 so as to have a predetermined distance from the substrate holder 5.

Formation of the gas barrier layer by using the above film-forming apparatus 10 can be achieved, for example, by the following procedure.

First, a substrate sheet is disposed on the substrate holder 5 of the film-forming apparatus 10, and inside of the chamber 1 is evacuated by a turbo molecular pump 6 and a rotary pump 7, to produce a vacuum state.

At this time, the distance between an upper face of the substrate sheet and the catalytic body 4 is set considering e.g. the heat resistance of the substrate sheet. Considering the heat resistance of the substrate sheet, the distance is preferably from 40 to 300 mm, more preferably from 60 to 200 mm.

Further, the pressure in the chamber 1 in vacuum state is preferably at most 9×10⁴ Pa, more preferably at most 1×10⁴ Pa for the reason of easiness of eliminating impurities in a film.

Next, into the chamber 1 in vacuum state, a material gas is supplied from a first material gas supply unit 2 and/or a second material gas supply unit 3, and the material gas is made to contact with a heated catalytic body 5. As a result, the material gas is decomposed, and the decomposed product forms a film (gas barrier layer) on the substrate sheet.

The material gas is selected according to the composition of a gas barrier layer to be formed. For example, in a case of forming a gas barrier layer containing a Si compound as the main component, at least a gas that becomes a Si source is employed, and in a case of forming a gas barrier layer containing an Al compound as the main component, at least a gas that becomes an Al source is employed. As the case requires, a gas (e.g. ammonium (NH₃) gas) that becomes a N source, and a gas (e.g. oxygen (O₂) gas) that becomes an O source, etc. are used in combination. Further, in order to accelerate decomposition reaction, hydrogen gas may further be used in combination.

As the gas that becomes a Si source, a gas containing a silane compound is mentioned, and as the silane compound, silane (SiH₄), a silane halide that is a silane wherein a part or all of hydrogen atoms are substituted by halogen atoms such as chlorine atoms or fluorine atoms, etc. may be mentioned.

As the gas that becomes an Al source, e.g. trimethylaluminum (TMA) may be mentioned.

In a case of using O₂ gas as the material gas, in order to reduce oxidation of the catalytic body, it is preferred to supply only O₂ gas from the second material gas supply unit 3 separately from other gases.

The temperature of the catalytic body 5 in contact with the material gas is not particularly limited so long as it is a temperature at which the material gas can be decomposed. The temperature is usually about from 300 to 1,900°C.

The pressure in the chamber 1 at a time of supplying the material gas (at a time of film-forming) is preferably from 0.3 to 100 Pa, more preferably from 1 to 50 Pa considering e.g. the density of a film to be formed.

In process 1 of the present invention, the film thickness of the gas barrier layer to be formed can be adjusted by film-forming time.

Here, process 1 of the present invention is not particularly limited to the above embodiment, and other known catalytic CVD methods can be used. For example, not only a batch type but a roll to roll type film-forming apparatus may be employed.

### <Process 2 for producing laminate>

Process 2 for producing a laminate of the present invention is a process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by an ALD method (that is an atomic layer deposition method).

Explanations of the substrate sheet and the gas barrier layer are the same as explanations of the substrate sheet and the gas barrier layer of the laminate of the present invention.

Process 2 of the present invention can be carried out by employing a known film-forming apparatus of an ALD method. As a film-forming apparatus, there is e.g. a batch type.

For example, in a case of employing a batch type film-forming apparatus, process 2 of the present invention can be conducted by carrying out a step of disposing a substrate sheet on a substrate holder in a vacuum container having the substrate holder for holding the substrate sheet inside the vacuum container,
a step of supplying an organic metal gas in the vacuum container to form a metal atomic layer, and
a step of removing the organic metal gas in the vacuum container and supplying an oxidizing gas and/or a nitriding gas into the vacuum container to bond the metal atoms constituting the metal atomic layer to oxygen atoms and/or nitrogen atoms.

Now, process 2 of the present invention will be described in detail with reference to an example of embodiment.

Fig. 3 is a schematic construction view showing an embodiment of a batch-type film-forming apparatus 20 to be employed for film-forming using an ALD method.

The film-forming apparatus 20 comprises a chamber (vacuum container) 11, a material gas supply line 12 for supplying an organic metal gas (material gas) into the chamber 11, a reactive gas supply line 13 for supplying an oxidizing gas and/or a nitriding gas (reactive gas) into the chamber 11, a purge gas supply line 14 for supplying a purge gas into the chamber 11, a substrate holder 15, and an evacuation means for evacuating inside the chamber 11 to produce a vacuum state. The evacuation means is constituted by a rotary pump 16.

To the substrate holder 15, a heating means, not shown, is connected so that the substrate holder 15 can be heated.

Formation of the gas barrier layer by using the above film-forming apparatus 20 can be achieved, for example, by the following procedure.

First, a substrate sheet is disposed on the substrate holder 15 of the film-forming apparatus 20, and inside of the chamber 11 is evacuated by a turbo molecular pump 16 and a rotary pump (not shown), to produce a vacuum state.

The pressure in the chamber 11 at this time is preferably at most 9×10⁴ Pa, more preferably at most 1×10⁴ Pa from the viewpoint of easiness of eliminating impurities in the film.

Next, the substrate holder 15 is heated so that the surface temperature of the substrate sheet becomes a predetermined reaction temperature, and an organic metal gas is supplied from the material gas supply line 12. Consequently, the organic metal gas is decomposed, and the decomposed product is bonded to the surface of the substrate sheet to form a metal atomic layer.

The organic metal gas is an organic metal compound in a gas form, and the organic metal compound is a compound containing a metal atom and an organic group bonded to the metal atom. As the organic group, a hydrocarbon group such as an alkyl group is mentioned.

The organic metal compound may be any compound so long as it has in a gas form at a temperature of about from 80 to 300°C and a pressure of about from 0.1 to 50 Pa, and which can react with a reactive gas to form a M (metallic atom)-O (oxygen atom) bond or a M-N (nitrogen atom) bond. The compound can be appropriately selected from known organic metal compounds (organic aluminum compound, organic silane compound etc.) to be used for an ALD method according to an inorganic compound constituting a gas barrier layer to be formed.

As the organic metal compound, more specifically, a compound represented by the following general formula is mentioned.

M(R¹)ₘ (R²)ₙ₋ₘ

[in the formula, M represents a metal atom, R¹ represents a hydrocarbon group, R² represents a hydrogen atom, a halogen atom or an alkoxy group, n represents the valency of M, and m is an integer of from 1 to n.]

M may be silicon, aluminum, titanium, zinc, magnesium, etc.

R¹ is preferably a linear or branched alkyl group or alkenyl group, more preferably an alkyl group. The number of carbon atoms in the alkyl group or the alkenyl group is preferably 1 to 3, particularly preferably 1.

As the halogen atoms in R², fluorine atoms, chlorine atoms, bromine atoms, iodine atoms, etc. may be mentioned, and as the alkoxy group, a C₁₋₃ alkoxy group is preferred.

n represents the valency of M, and n changes depending on the sort of M. For example, when M is aluminum, n is 3, and when M is a silicon atom, n is 4.

m is particularly preferably n from the viewpoint of easiness of decomposition of material gas.

The organic metal compound is preferably one represented by the above general formula M(R¹)ₘ(R²)ₙ₋ₘ wherein M is silicon or aluminum, that is, an organic silicon compound or an organic aluminum compound. Among them, for the reason of low decomposition temperature, an organic aluminum compound is preferred.

The organic aluminum compound is particularly preferably one whose R¹ is an alkyl group and m is 3, that is a trialkylaluminum, and among them, trimethylaluminum is preferred.

The surface temperature of the substrate sheet at a time of supplying the organic metal gas changes depending on the organic metal gas to be used, and it is usually about from 80 to 250°C.

The pressure in the chamber 11 at the time of supplying the organic metal gas is preferably from 0.1 to 50 Pa, more preferably from 0.4 to 30 Pa considering the density of a film to be formed.

Subsequently to the formation of the metal atomic layer, a purge gas is supplied from the purge gas supply line 14 in order to remove the organic metal gas, its decomposed product and byproduct, etc. remaining in the chamber 11.

Thereafter, as a reaction gas, an oxidizing gas and/or a nitriding gas is introduced from a reactive gas supply line 13. Consequently, metal atoms in the metal atomic layer react with the reactive gas, and the metal atoms are bonded to oxygen atoms and/or nitrogen atoms to form a gas barrier layer containing the metal atoms, the oxygen atoms and/or nitrogen atoms. Further, when a part of organic groups bonded to the metal atoms of the organic metal gas remain, the gas barrier layer further contains carbon atoms.

In process 2, the thickness of a gas barrier layer formed is increased by repeating the series of operations from formation of the aluminum atomic layer to formation of the layer of oxygen atoms and/or nitrogen atoms. Accordingly, it is possible to adjust the thickness of the gas barrier layer by adjusting the number of operations.

In the case of repeating the operations a plurality of times, the organic metal gas or the reactive gas to be supplied may be the same or different.

As the purge gas, N₂ gas, Ar gas, etc. may be mentioned.

As the oxidizing gas, for example, H₂O gas, O₂ gas, ozone gas, etc. may be mentioned, and O₂ gas or ozone gas is preferred. Further, as described in JP-A-2002-161353, an organic ozonide, oxygen atoms containing unpaired electron, an organic peroxide, an organic peracid, etc. may be employed.

As the nitriding gas, nitrogen gas, ammonium gas, NO₂ gas, etc. may be mentioned, and nitrogen gas or ammonium gas is preferred.

The surface temperature of the substrate sheet at the time of supplying the reactive gas is preferably from 80 to 250°C, more preferably from 100 to 200°C considering decomposition property of the material gas.

The pressure in the chamber 11 at the time of supplying the reactive gas is preferably from 0.1 to 50 Pa, more preferably from 0.4 to 30 Pa considering the density of a film to be formed.

In process 2, the thickness of a gas barrier layer formed is increased by repeating the series of operations from formation of the aluminum atomic layer to formation of the layer of oxygen atoms and/or nitrogen atoms. Accordingly, it is possible to adjust the thickness of a finally obtained gas barrier layer, by adjusting the number of operations.

In a case of carrying out the operations a plurality of times, the organic metal gas or the reactive gas in these operations may be the same or different.

Here, process 2 of the present invention is not limited to the above embodiment, and a known ALD method may be employed.

### EXAMPLES

Now, specific examples of the above embodiments will be described as Examples. However, the present invention is not limited to the following Examples.

In each of the following Examples, the thickness of the gas barrier layer (SiON film, Al₂O₃ film, etc.) was measured by using a spectral ellipsometry apparatus (model name "M-2000DI", manufactured by J.A.WOOLLAM JAPAN), and optical fitting was carried out by WVASE32 (manufactured by J.A.WOOLLAM).

### EXAMPLE 1

Formation of a SiON film was carried out by a catalytic CVD method in the following procedure by employing as a film-forming apparatus, a film-forming apparatus (manufactured by Ishikawa Seisakusho) having the same construction as the film-forming apparatus 10 shown in Fig. 2.

A substrate (an ETFE film of 100 µm thick, product name: AFLEX manufactured by Asahi Glass Company, Limited) was disposed on a substrate holder 5, and the distance between a catalytic body 4 (tungsten wire) and a surface of the substrate was set to be 200 mm. Inside of the chamber was evacuated by a turbo molecular pump 6 and a rotary pump 7 to be at most 5×10⁻⁴ Pa, and thereafter, as a material gas, 8 sccm of SiH₄ gas, 50 sccm of NH₃ gas and 1,200 sccm of H₂ gas were introduced from a first material gas supply unit 2, 5 sccm of O₂ gas was introduced from a second material gas supply unit 3, and the catalytic body 4 was heated to 1,800°C to form 100 nm of SiON film (gas barrier layer) on the substrate. The pressure in the chamber at the time of film-forming was set to be 30 Pa.

### EXAMPLE 2

By using a film-forming apparatus (Savannah S200, manufactured by Cambridge Nano Tech) having the same construction as a film-forming apparatus 20 shown in Fig. 3, film-forming of an Al₂O₃ film was carried out by an ALD method in the following procedure.

A substrate (an ETFE film of 100 µm thick, product name: AFLEX manufactured by Asahi Glass Company, Limited) was disposed in a chamber 11, and inside the chamber was evacuated to be at most 5×10⁻⁵ Pa by a rotary pump 16.

Next, a substrate holder 15 was heated so that the surface temperature of the substrate became 110°C, and trimethyl aluminum (manufactured by Sigma Aldrich) was introduced from a material gas supply line 12 to form an aluminum atomic layer. Subsequently, N₂ purge gas was supplied from a purge gas supply line 14 to purge inside of the chamber 11, and H₂O gas was introduced from a reactive gas supply line 13 to form an oxygen atomic layer. The temperatures at times of forming the aluminum atomic layer and the oxygen atomic layer were each 110°C.

By repeating a series of operations from the formation of the aluminum atomic layer to the formation of the oxygen atomic layer, an Al₂O₃ film (gas barrier layer) having a film thickness of 20 nm was finally obtained.

### COMPARATIVE EXAMPLE 1

By using a sputtering apparatus (manufactured by Tokki), formation of an Al₂O₃ film was carried out by a sputtering method in the following procedure.

A substrate (an ETFE film of 100 µm thick, product name: AFLEX manufactured by Asahi Glass Company, Limited) was disposed in a chamber of the sputtering apparatus, and evacuation was carried out so that the pressure became about 5×10⁻⁴ Pa, and thereafter, using aluminum as a target, 50 sccm of Ar gas and 3 sccm of O₂ gas were introduced into the chamber and discharge was carried out at a DC voltage of 320 V. By opening and closing a shutter and thereby controlling a film-forming time, 20 nm of an aluminum oxide thin film (gas barrier layer) was formed.

With respect to laminates obtained in Examples 1 and 2 and Comparative Example 1, the following measurement and evaluation were carried out.

### <Measurement of C1s spectrum by ESCA>

With respect to a laminate obtained in each Example, a C1s spectrum of a surface of a substrate on which the gas barrier layer was laminated was measured.

From the above measurement result, positions of peaks (1) and (2) were obtained. Further, the peak intensity ratio between peaks (1) and (2) (intensity of peak (1)/intensity of peak (2)) was calculated. Table 1 shows these results. Further, Fig. 1 shows a C1s spectrum of each of the laminate (ALD-AIO) of Example 2 and the laminate (sputter AIO) of Comparative Example 1 in a range of from 295 to 280 eV.

Here, as a reference example, a C1s spectrum of the substrate (ETFE film of 100 µm thick, product name: AFLEX manufactured by Asahi Glass Company, Limited) employed in each Example is shown in Table 1 and Fig. 1.

In Fig. 1, the horizontal axis shows binding energy (B.E.), and the vertical axis shows peak intensity ratio between peaks (1) and (2) (intensity of peak (1)/ intensity of peak (2)).

### <Evaluation of adhesion (measurement of adhesion strength)>

A laminate obtained in each Example was cut into a size of 10 cm × 10 cm, and the laminate thus cut and an EVA film (W25CL manufactured by Bridgestone Corporation) cut into the same size were disposed so that the order would be ETFE film/gas barrier layer/EVA film and subjected to thermal compression bonding by a press machine (manufactured by Asahi Glass Company, Limited) under such conditions that the pressure was 10 kgf/cm, the area was 120 cm², the temperature was 150°C and the time was 10 minutes, to obtain a test piece.

Then, each test piece was cut into a size of 1 cm × 10 cm, and by using a Tensilon universal tester (RTC-1310A) manufactured by ORIENTEC CO., LTD., the adhesion strength (peel bond strength, unit: N/cm) was measured by a 180° peeling test at a tensile speed of 50 mm/min in accordance with JIS K6854-2.

The measurement of the adhesion strength was carried out before the weather resistance test (SWOM) (initial) and after the test (100 hours and 500 hours). Here, with respect to each test piece, whose adhesion strength after 100 hour-test was less than 5 N/cm, measurement after 500 hour-test was not carried out.

Weather resistance test (SWOM): carried out by using a sunshine carbon arc type weather resistance tester (Sunshine weather meter S300 manufactured by Suga Test Instruments Co., Ltd.) in accordance with JIS B7753.

Table 2 shows the results.

### <Evaluation of water vapor barrier property (measurement of water vapor transmission rate)>

Water vapor transmission rate (hereinafter abbreviated to WVTR) of the laminate obtained in each Example was measured by a cup method according to JIS Z0208.
Table 2 shows the results.

WVTR is the amount of water vapor passing through a film-shaped material having a unit area in a predetermined time. According to JIS Z0208, at a temperature of 25°C or 40°C, when a partition film of a moisture proof packing material is employed, an air on one side of the film is maintained to have a relative humidity of 90% and an air on the other side of the film is maintained to be a dry state by a moisture-absorbing agent, then, the mass (g) of water vapor passing through the partition film in 24 hours per 1 m² of the material (unit: g/m²/day) is defined as WVTR of the material. In each Example, WVTR at a temperature of 40°C was measured.

### <Overall judgment>

From the evaluation results of adhesion and water vapor barrier property, overall judgments of adhesion and moisture-proof property were carried out according to the following judgment standards. Table 2 shows the results.

### (Judgment standards)

○: An Example wherein the initial adhesion strength is at least 5 N/cm, the adhesion strength after 100 hours of the weather resistance test is at least 5 N/cm, and the water vapor transmission rate is at most 0.2 g/m²/day.
×: An Example which satisfies at least one of the following (1) to (3). (1) Initial adhesion strength is less than 5 N/cm. (2) Adhesion strength after 100 hours of the weather resistance test is less than 5 N/cm. (3) The water vapor transmission rate exceeds 0.2 g/m²/day.

**TABLE 1**

| | Construction | C1s spectrum at ETFE film surface | | |
|---|---|---|---|---|
| | | Peak (1) (eV) | Peak (2) (eV) | Peak intensity ratio ((1)/(2)) (eV) |
| Ex. 1 | ETFE/SiON (100 nm, catalytic CVD) | 290.6 | 285.8 | 0.96 |
| Ex. 2 | ETFE/Al₂O₃ (20 nm, ALD) | 290.4 | 285.7 | 0.93 |
| Comp. Ex. 1 | ETFE/Al₂O₃ (20 nm, sputtering) | 289.6 | 284.3 | 0.25 |
| Ref. Ex. | ETFE | 290.6 | 285.9 | 1.00 |

**TABLE 2**

| | Adhesion strength (N/cm) | | | WVTR (g/m²/day) | Overall judgment |
|---|---|---|---|---|---|
| | Initial | SWOM 100h | SWOM 500h | | |
| Ex. 1 | 23.4 | 20.9 | 14.0 | 0.1 | ○ |
| Ex.2 | 24.1 | 21.8 | 15.7 | 0.2 | ○ |
| Comp. Ex. 1 | 0.1 | 0.1 | - | 0.1 | × |

As shown in Table 1 and Fig. 1, in Comparative Example 1 wherein a gas barrier layer was formed by a sputtering method, the positions of peaks (1) and (2) significantly shifted in minus direction from those of Reference Example. Further, the peak intensity ratio became significantly low. On the other hand, in Examples 1 and 2 wherein a gas barrier layer was formed by a catalytic CVD method or an ALD method, shift of their peaks were little. Further, the peak intensity ratios in Examples 1 and 2 were as high as at least 0.93, and there were little difference from the peak intensity ratio (1.00) of Reference Example.

As shown in Table 2, laminates of Examples 1 and 2 showed high adhesion strengths in terms of initial adhesion strength and adhesion strength after the weather resistance test, and they had high water vapor barrier properties. On the other hand, the laminate of Comparative Example 1 showed a high water vapor barrier property, but even the initial adhesion was low.

### INDUSTRIAL APPLICABILITY

The laminate of the present invention is excellent in weather resistance and gas barrier property, and is also excellent in adhesion between layers and its durability. Accordingly, the laminate is useful as a protection sheet for a solar cell module. Further, the laminate of the present invention is applicable not to a protection sheet for a solar cell module, but also to various applications to which weather resistance or gas barrier property is required. As such an application, for example, a protection sheet for a display, a protection film member for an organic EL illumination, a protection film member for an organic EL display, a protection film member for an electric paper, a protection member for a mirror for solar thermal power generation, a packing member for foods, a packing member for drugs and medicines, etc. may be mentioned.

The entire disclosure of Japanese Patent Application No. 2010-181207 filed on August 13, 2010 including specification, claims, drawings and summary is incorporated herein by reference in its entirety.

### REFERENCE SYMBOLS

1: chamber (vacuum container), 2: first material gas supply unit, 3: second material gas supply unit, 4: catalytic body, 5: substrate holder, 6: turbo molecular pump, 7: rotary pump, 10: film-forming apparatus, 11: chamber (vacuum container), 12: material gas supply line, 13: reactive gas supply line, 14: purge gas supply line, 15: substrate holder, 16: rotary pump, 20: film-forming apparatus

## Claims

1. A laminate which comprises a substrate sheet containing a fluororesin, and a gas barrier layer containing, as the main component, an inorganic compound composed of a metal and at least one member selected from the group consisting of oxygen, nitrogen and carbon, the gas barrier layer being directly laminated on at least one surface of the substrate sheet;
wherein in a C1 s spectrum of a surface of the substrate sheet on which the gas barrier layer is laminated, that is measured by X-ray photoelectron spectroscopy, the position of the highest peak present within a binding energy range of from 289 to 291 eV is present within a range of from 290.1 to 290.6 eV.

2. The laminate according to Claim 1, wherein the fluororesin contains an ethylene/tetrafluoroethylene copolymer.

3. The laminate according to Claim 1 or 2, wherein in the C1 s spectrum of the surface of the substrate sheet on which the gas barrier layer is laminated, as measured by X-ray photoelectron spectroscopy, the position of the maximum peak present in a binding energy range of from 284 to 286 eV is present within a range of from 285.0 to 285.9 eV.

4. The laminate according to any one of Claims 1 to 3, wherein the inorganic compound contains at least one member selected from the group consisting of a Si compound and an Al compound.

5. The laminate according to Claim 4, wherein the inorganic compound contains at least one member selected from the group consisting of silicon oxide, silicon nitride, silicon oxynitride, silicon oxynitric carbide and aluminum oxide.

6. The laminate according to any one of Claims 1 to 5, which is a protection sheet for a solar cell module.

7. A process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by a catalytic vapor deposition method.

8. A process for producing a laminate comprising a substrate sheet and a gas barrier layer directly laminated on the substrate sheet, the process comprising forming the gas barrier layer containing as the main component an inorganic compound composed of a metal and at least one member selected from the group consisting of oxygen, nitrogen and carbon on at least one surface of the substrate sheet containing a fluororesin, by an atomic layer deposition method.

9. The process according to Claim 7 or 8, wherein the metal is silicon or aluminum.
